# EUROPEAN PATENT APPLICATION

(11) **EP 0 691 418 A1**
(43) Date of publication of application: **10.01.1996**
(21) Application number: 95401546.7
(22) Date of filing: 28.06.1995
(51) Int. Cl.: C23C 14/08, C30B 23/02, C30B 29/22, C30B 29/32, C23C 14/24

(54) **Process for preparing high crystallinity oxide thin film**

(30) Priority: 04.07.1994 JP 174756/94
(71) Applicant: Sumitomo Electric Industries, Ltd., Osaka 541 (JP)
(72) Inventor: Nakamura, Takao, Cabinet Ballot-Schmit, F-75116 Paris (FR)
(74) Representative: Ballot, Paul Denis Jacques

(57) **Abstract**

A process for preparing an oxide superconductor thin film which has a high crystallinity, clean and excellent superconductive surface on a substrate by reactive co-evaporation. The reactive co-evaporation process comprises the steps of evacuating the vacuum chamber to a pressure of 1 × 10⁻⁹ torr or lower, supplying an oxidizing gas selected from the group consisting of O₂ including not less than 5 volume percent O₃, pure N₂O and pure NO₂ so that a pressure in the proximity of the substrate becomes 6 × 10⁻⁶ to 8 × 10⁻⁵ Torr while a pressure in the proximity of the evaporation source becomes 1 × 10⁻⁹ Torr or lower, heating the substrate, and emitting a molecular beam onto the heated substrate so that the molecular beam is oxidized on and near the substrate and an oxide superconductor film is deposited on the substrate. A similar process for the preparation of oxide dielectric thin films, eg. SrTiO₃ is also described.

## Description

### Background of the Invention

### Field of the invention

The present invention relates to a process for preparing high crystallinity oxide thin films, and more specifically to an improved MBE (Molecular Beam Epitaxy) process so called a reactive co-evaporation process particularly for preparing oxide superconductor thin films, which has clean surfaces, high crystallinity and excellent properties.

### Description of related art

Oxide superconductors have been considered to have higher critical temperatures than those of metal superconductors, and therefore to have high possibility of practical use. For example, Y-Ba-Cu-O type oxide superconductor has a critical temperature higher than 80 K and it is reported that Bi-Sr-Ca-Cu-O type oxide superconductor and Tl-Ba-Ca-Cu-O type oxide superconductor have critical temperatures higher than 100 K.

In order to manufacture superconducting devices and superconducting integrated circuit of multi-layer structure, it is necessary to form a layered film including an oxide superconductor thin film and a thin film of another material such as an insulator thin film, a dielectric thin film or a semiconductor thin film. In the layered film, a clean upper surface and high crystallinity are required of a lower thin film. If contaminants or unexpected oxide are formed at an upper surface of the lower thin film, the stacked thin films may become physically and electrically discontinuous or an unnecessary weak link of Josephson junction may be formed at the interface. The discontinuity and unnecessary weak link have adverse effects on the operations of the superconducting device and the superconducting integrated circuit so that their performance become below the determined values or do not operate at all.

The coherence length of the oxide superconductor is very short, therefore, special attention should be given to the contamination of the upper surface of the lower thin film.

In order to clean the surface of the oxide superconductor thin film, in a prior art, the oxide superconductor thin film is heated under a high vacuum so as to vaporize the contaminants. However, oxygen of the oxide superconductor crystal is unstable and easily escapes when the oxide superconductor thin film is heated under a high vacuum. If some amount of oxygen escapes from the oxide superconductor crystal, the critical temperature of the oxide superconductor lowers or the oxide superconductor loses its superconductivity.

Therefore, the oxide superconductor thin film or thin films of other materials which is used a lower layer of a stacked multi-layer structure is required to have a clean outermost surface, high crystallinity, and excellent characteristics and properties as deposited.

### Summary of the Invention

Accordingly, it is an object of the present invention to provide a process for preparing an oxide superconductor thin film which has a clean upper surface, high crystallinity and excellent superconducting characteristics without any post treatment, which has overcome the above mentioned defects of the conventional ones.

Another object of the present invention to provide a process for preparing an oxide dielectric thin film which has excellent dielectric characteristics.

The above and other objects of the present invention are achieved in accordance with the present invention by a process for preparing a film formed of an oxide superconductor on a substrate by reactive co-evaporation conducted by using an MBE apparatus comprising a vacuum chamber wherein an oxidizing gas is supplied in the proximity of the substrate so that pressure around the substrate is locally elevated and at least one evaporation source wherein the process comprising the steps of;
evacuating the vacuum chamber to a pressure of 1 × 10⁻⁹ torr or lower;
supplying an oxidizing gas selected from the group consisting of O₂ including not less than 5 volume percent O₃, pure N₂O and pure NO₂ so that a pressure in the proximity of the substrate becomes 6 × 10⁻⁶ to 8 × 10⁻⁵ Torr while a pressure in the proximity of the evaporation source becomes 1 × 10⁻⁹ Torr or lower;
heating the substrate; and
emitting a molecular beam onto the heated substrate so that the molecular beam is oxidized on and near the substrate and an oxide superconductor film is deposited on the substrate.

This quite low background pressure means that there is no leak nor any gas generation in the vacuum chamber of the MBE apparatus. Therefore, no contaminant, for example hydrocarbons and metal carbides, is deposited on the oxide thin film prepared by the process in accordance with the present invention.

According to the present invention, the oxidizing gas is selected from the group consisting of O₂ including not less than 5 volume percent O₃, pure N₂O and pure NO₂. These gases have higher oxidizing than pure O₂ and it is favorable for preparing an oxide thin film by the reactive co-evaporation.

According to one preferable embodiment of the present invention, the substrate is cooled down to the room temperature after the oxide superconductor thin film was deposited, in the atmosphere in which the oxide superconductor thin film was deposited. In case of depositing an oxide superconductor thin film, while the substrate is cooled down, the oxide superconductor crystal system of the thin film is transformed from a tetragonal system to an orthorhombic system. At this stage, the oxide superconductor thin film should be in the oxidizing atmosphere, in order to get excellent superconducting characteristics.

In one preferred embodiment, the reactive co-evaporation is effected while the oxidizing gas is struck onto a deposition surface of the substrate. By this, the pressure of the oxidizing gas on the deposition surface of the substrate was further elevated.

In a preferred embodiment, the oxide is formed of a high-T_{c} (high critical temperature) oxide superconductor, particularly, formed of a high-T_{c} copper-oxide type compound oxide superconductor for example a Y-Ba-Cu-O type compound oxide superconductor material, a Bi-Sr-Ca-Cu-O type compound oxide superconductor material, and a Tl-Ba-Ca-Cu-O type compound oxide superconductor material.

In case of Y₁Ba₂Cu₃O_{7-δ} oxide superconductor, the reactive co-evaporation is preferably effected at a substrate temperature of 650 to 730 °C by using metal yttrium, metal barium and metal copper as evaporation sources. It is more preferable that the reactive co-evaporation is effected at a substrate temperature of 700 °C. If the substrate temperature is lower than 650 °C, the obtained Y₁Ba₂Cu₃O_{7-δ} oxide superconductor thin film constituted of polycrystals which includes *c*-axis orientated crystals and a-axis orientated crystals. On the contrary, if the substrate temperature exceeds 730 °C, metal copper molecules are not oxidized so that the Y₁Ba₂CU₃O_{7-δ} oxide superconductor can not obtained.

The above evaporation sources are preferably set to K cells. It is preferable that the temperature of the K cell of the metal yttrium is 1150 to 1350 °C, more preferable 1220 °C, the temperature of the K cell of the metal barium is 570 to 640 °C, more preferable 620 °C, and the temperature of the K cell of the metal copper is 950 to 1090 °C, more preferable 1000 °C. The temperatures of the K cells are determined by geometric arrangement of the MBE apparatus and the material which constitutes the crucibles.

The substrate can be formed of an insulating substrate, preferably an oxide single crystal substrate such as MgO, SrTiO₃, CdNdAlO₄, etc. These substrate materials are very effective in forming or growing a crystalline film having a high degree of crystallinity.

According to another aspect of the invention, there is provided a process for preparing a film formed of an oxide dielectric on a substrate by reactive co-evaporation conducted by using an MBE apparatus comprising a vacuum chamber wherein an oxidizing gas is supplied in the proximity of the substrate so that pressure around the substrate is locally elevated and at least one evaporation source wherein said process comprising the steps of;
evacuating the vacuum chamber to a pressure of 1 × 10⁻⁹ torr or lower;
supplying an oxidizing gas selected from the group consisting of O₂ including not less than 5 volume percent O₃, pure N₂O and pure NO₂ so that a pressure in the proximity of the substrate becomes 9 × 10⁻⁶ to 9 × 10⁻⁵ Torr while a pressure in the proximity of the evaporation source becomes 1 × 10⁻⁹ Torr or lower;
heating the substrate; and
emitting a molecular beam onto the heated substrate so that the molecular beam is oxidized on and near the substrate and an oxide dielectric film is deposited on the substrate.

The above and other objects, features and advantages of the present invention will be apparent from the following description of preferred embodiments of the invention with reference to the accompanying drawings.

### Brief Description of the Drawings

Figures 1 is a diagrammatic sectional view of a film deposition apparatus which can be used for carrying out the process in accordance with the present invention;
Figure 2 is a LEED (Low Energy Electron Diffraction) image of an oxide superconductor thin film prepared by the process in accordance with the present invention;
Figures 3 and 4 are XPS (X-ray Photoelectron Spectroscopy) spectra of an oxide superconductor thin film prepared by the process in accordance with the present invention;
Figure 5 shows graphs of dielectric constants of SrTiO₃ thin film prepared in accordance with the present invention at the room temperature against substrate temperatures at which the SrTiO₃ thin film were deposited;
Figure 6 shows graphs of dielectric constants of the SrTiO₃ thin films having thickness of 62, 125 and 250 nanometers prepared in accordance with the present invention against temperatures; and
Figure 7 shows graphs of dielectric constants of the SrTiO₃ thin film having a thickness of 250 nanometers prepared in accordance with the present invention against electric fields.

### Description of the Preferred embodiments

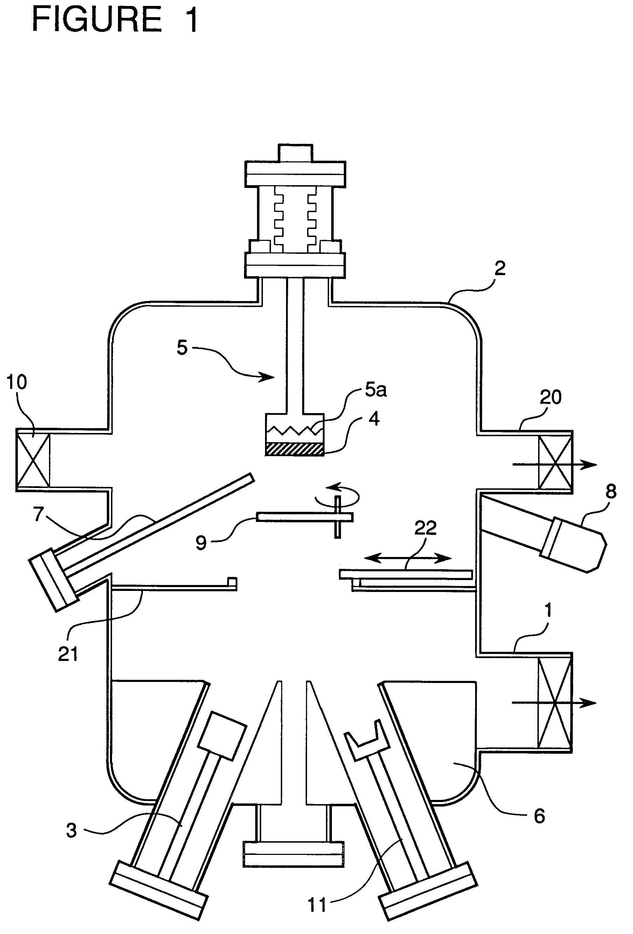

Referring to Figure 1 there is shown a diagrammatic sectional view of a film deposition apparatus which can be used for carrying out the process in accordance with the present invention.

The shown film deposition apparatus basically includes a vacuum chamber 2 provided with a main evacuating apparatus 1, at least one K (Knudsen's) cell and at least one electron beam gun 11 provided at a bottom of the vacuum chamber 2, and a sample holder 5 provided at a top of the vacuum chamber 2 for holding a substrate 4 on which a film is to be deposited. The sample holder 5 is associated with a heater 5a for heating the substrate. In addition, the vacuum chamber 2 is also provided with a port 10 for exchanging a sample, a liquid nitrogen shroud 6 for forming a cold trap around an evaporation source of the K cell, and a RHEED (Reflecting High Energy Electron Diffraction) device 8 for observing a thin film roughness during the deposition. In front of the substrate held by the sample holder, a shutter 9 is located for controlling a deposition time during the deposition process. The K cell 3 and the electron beam gun 11 are provided with an openable shutter 19.

In addition, a gas supplying apparatus 7 is provided so as to introduce an oxidizing gas such as O₂, O₃, NO₂, N₂O, etc. in proximity of the substrate 4 held by the sample holder 5, so that the oxidizing gas can be supplied to form an oxygen-enriched atmosphere in the proximity of the substrate 4 in order to oxidize metal molecular beams incoming from the evaporation source in the course of the film deposition.

Furthermore, the film deposition apparatus additionally includes a partitioning plate 21 for dividing the vacuum chamber 2 into a first sub-chamber which is constituted of a lower portion of the vacuum chamber defined below the partitioning plate 21 and which is coupled to the K cell 3, the electron beam gun 11 and the main evacuating apparatus 1, and a second sub-chamberwhich is constituted of an upper portion of the vacuum chamber defined above the partitioning plate 21 and in which sample holder 5 is located. The partitioning plate 21 includes a through opening 23 formed at a center thereof. The position of the opening 23 is determined to ensure that a beam emitted from K cell 3 and the electron beam gun 11 toward the substrate 4 is not obstructed by the partitioning plate 21. In addition, the size of the opening 23 is determined to enable restricted molecular flows between the first sub-chamber and the second sub-chamberso that a pressure difference can be created between the first sub-chamber 2A and the second sub-chamberwhen the opening 23 is open. Therefore, the partitioning plate 21 having the through opening 23 constitutes a vacuum impedance.

A gate valve 22 is provided on the partitioning plate 21 for hermetically closing the opening 23 of the partitioning plate 21, so as to completely shut off the molecular flows between the first sub-chamber 2A and the second sub-chamberwhen the gate valve 22 is closed. An opening and closing of this gate valve 22 is controlled from the outside of the film deposition apparatus by a not-shown means.

In addition , an auxiliary evacuating apparatus 20 is coupled to the second sub-chamberfor evacuating the second sub-chamberto an ultra-high vacuum when the gate valve 22 is closed. The auxiliary evacuating apparatus 20 is constituted of a cryopump. On the other hand, the main evacuating apparatus 1 is constituted of a diffusion pump.

### Example 1

According to the present invention, c-axis orientated Y₁Ba₂Cu₃O_{7-δ} oxide superconductor were prepared by using the apparatus of Figure 1.

First, a MgO (100) substrate 4 was set to the sample holder 5, and metal yttrium, metal barium and metal copper were set to three different K cells 3 as evaporation sources. Thereafter, the chamber 2 was closed and the gate valve 22 was opened. The vacuum chamber 2 was evacuated by the main evacuating apparatus 1 and the auxiliary evacuating apparatus 20 to an ultra-high vacuum of which the pressure was lower than 1 × 10⁻⁹ Torr in which background pressure the film deposition by the co-evaporation process was available. Succeedingly, an oxidizing gas of O₂ including 70 volume percent O₃ was supplied from the nozzle 7 so that the pressure near the substrate 4 in the second chamberbecame 5 × 10⁻⁵ Torr.

As mentioned above, the vacuum chamber 2 was provided with the vacuum impedance (the partitioning plate 21 having the through opening 23), a pressure difference of about one digit or more was created between the first sub-chamber and the second sub-chamber. Pressure of the first sub-chamber was maintained ultra low so that metals evaporation sources were not oxidized and vapors could be efficiently generated after the oxidizing was supplied. In addition, the oxidizing gas jetted from the nozzle 7 was struck onto a deposition surface of the substrate, the pressure of the oxidizing gas on the deposition surface of the substrate was further elevated.

Then, the substrate 4 was heated by the heater 5a to a temperature of 700 °C. The K cell 3 of metal yttrium was heated to a temperature of 1220 °C, the K cell 3 of metal barium was heated to a temperature of 620 °C and the K cell 3 of metal copper was heated to a temperature of 1000 °C.

When molecular beams had become to be stably generates from the evaporation sources, the shutters 9 and 19 were opened so as to start deposition of the oxide superconductor thin film onto the substrate 4. At this time, a surface roughness of this deposited film was observed by the RHEED device. The oxide superconductor thin films were grown up to a thickness of 90 nanometers at a deposition rate of 1 nanometer/minute. The deposition rate is preferably 0.5 to 2 nanometers/minute.

When the oxide superconductor thin film had reached a thickness of 90 nanometers, the substrate 4 was cooled down to the room temperature. While the substrate 4 was cooled down, it was maintained in the condition in which the oxide superconductor thin film was deposited.

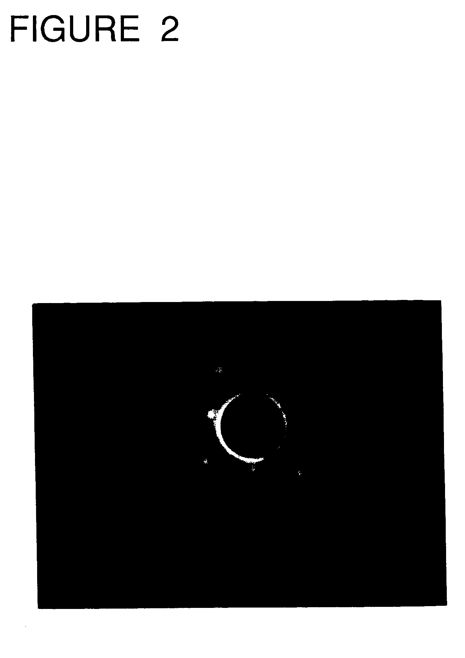

After the oxide superconductor thin film were obtained, crystal structures and surface conditions of the oxide superconductor thin films were evaluated LEED and XPS without exposing the oxide superconductor thin film to the air. It became clear that the oxide superconductor thin films were c-axis orientated Y₁Ba₂Cu₃O_{7-δ} oxide superconductor thin films. The results are shown in Figures 2, 3 and 4.

Each of Figures 2A and 2B shows a LEED image of the oxide superconductor thin film prepared by the above process in accordance with the present invention. In Figure 2, some spots are observed. This reveals such a fact that the oxide superconductor thin film has a crystalline surface.

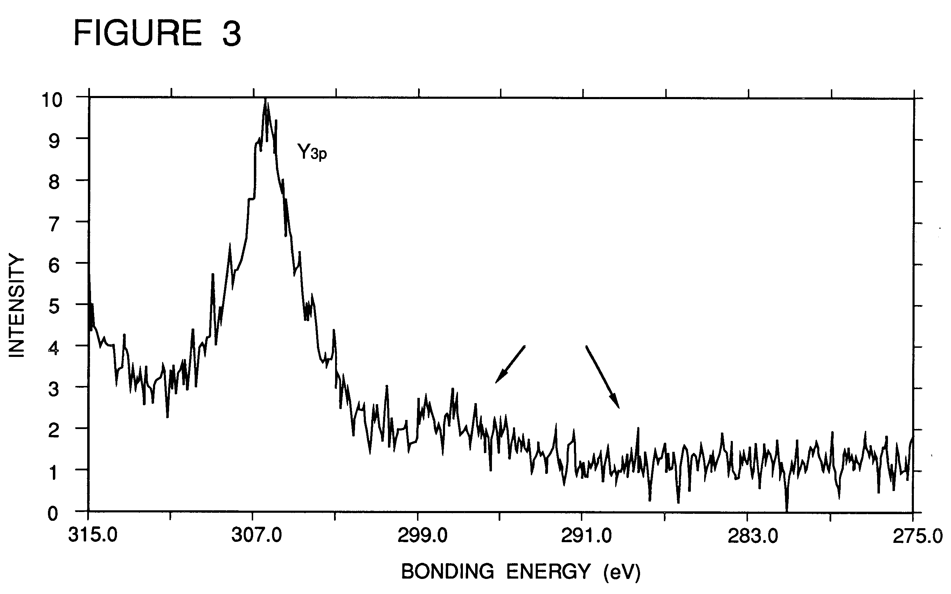

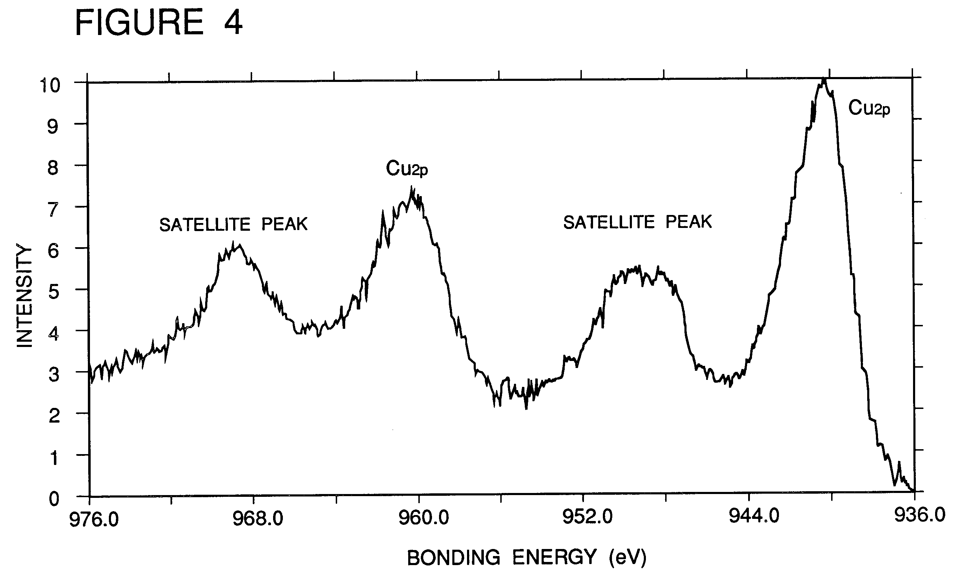

Figures 3 and 4 shows XPS spectra of an oxide superconductor thin film prepared by the above process in accordance with the present invention. The same XPS spectra were obtained for all the oxide superconductor thin film prepared by the above process. Figure 3 shows XPS spectra in a range in which 3p peak of yttrium and a peak of C can be observed. In Figure 3, no peak of C can be observed. Therefore, there is no composition of C which is a contaminant on the surface of the oxide superconductor thin film prepared by the above process in accordance with the present invention so that the surface is clean.

Figure 4 shows XPS spectra in a range in which peaks of Cu can be observed. In Figure 4, intensive satellite peaks of Cu can be observed. This reveals such a fact that the surface of the oxide superconductor thin film prepared by the above process in accordance with the present invention has excellent superconductivity.

As explained above, an oxide superconductor thin film which has an excellent surface condition can be obtained without any post-deposition treatment by the process in accordance with the present invention. The oxide superconductor thin film prepared by the process in accordance with the present invention has a high crystallinity, clean and excellent superconductive surface. Therefore, the oxide superconductor thin film is suitable for a lower layer of a layered film.

### Example 2

Thin films of SrTiO₃ dielectric oxide were prepared by using the apparatus of Figure 1.

A SrTiO₃ (100) substrate 4 including 0.05 % Nb was set to the sample holder 5, and metal strontium and metal titanium were set to two K cells 3 as evaporation sources. Thereafter, the chamber 2 was closed and the gate valve 22 was opened. The vacuum chamber 2 was evacuated to an ultra-high vacuum of which the pressure was lower than 1 × 10⁻⁹ Torr and an oxidizing gas of O₂ including O₃ was supplied from the gas supplying device 7 so that the pressure near the substrate 4 in the second chamber became 7 × 10⁻⁵ Torr.

The pressure in vicinity of the substrate 4 preferably ranges from 9 × 10⁻⁶ Torr to 9 × 10⁻⁵ Torr. If the pressure in vicinity of the substrate 4 is too low, the deposited SrTiO₃ thin film does not have high crystallinity and high dielectric constant. If the pressure in vicinity of the substrate 4 is too high, a surface of the deposited SrTiO₃ thin film may be contaminated.

Each of gases of O₂ including 8 volume percent O₃ and O₂ including 70 volume percent O₃ was used as the oxidizing gas. In this connection, a maximum O₃ content of the oxidizing gas of the apparatus of Figure 1, which could be supplied was on the order of 70 volume percent near the substrate 4. O₃ was unstable and partially decomposed during supply. Therefore, even if pure O₃ was supplied, only O₂ including 70 or a little more volume percent O₃ reached near the substrate 4.

The vacuum chamber 2 was provided with the vacuum impedance, a pressure difference of about one digit or more was created between the first sub-chamber and the second sub-chamber. Pressure of the first sub-chamber was maintained ultra low so that metals evaporation sources were not oxidized and vapors could be efficiently generated after the oxidizing was supplied. In addition, the oxidizing gas jetted from the gas supplying device 7 was struck onto a deposition surface of the substrate, the pressure of the oxidizing gas on the deposition surface of the substrate was further elevated.

Then, the substrate 4 was heated to a temperature of 480 °C. The K cell 3 of metal strontium was heated to a temperature of 520 °C and the K cell 3 of metal titanium was heated to a temperature of 1500 °C. The substrate temperature is preferably 430 to 580 °C, the temperature of metal strontium is preferably 450 to 600 °C and the temperature of metal titanium is preferably 1430 °C to 1550 °C.

When molecular beams had become to be stably generates from the evaporation sources, the shutters 9 and 19 were opened so as to start deposition of the dielectric oxide thin film onto the substrate 4. At this time, a surface of this deposited film was observed by the RHEED device. The dielectric oxide thin film was grown up at a deposition rate of 1.2 nanometer/minute. The deposition rate is preferably 0.5 to 2 nanometers/minute.

When the dielectric oxide thin film had reached a predetermined thickness, the substrate 4 was cooled down to the room temperature. While the substrate 4 was cooled down, it was maintained in the condition in which the dielectric oxide thin film was deposited.

After the dielectric oxide thin film was obtained, a crystal structure and a surface condition of the dielectric oxide thin film was evaluated LEED and XPS without exposing the dielectric oxide thin film to the air. In addition, dielectric properties of the SrTiO₃ thin film were evaluated.

By observation of LEED images of the dielectric oxide thin films, it became clear that the dielectric oxide thin films had a crystalline surfaces, and higher crystallinity of the dielectric oxide thin films were obtained by higher O₃ contents.

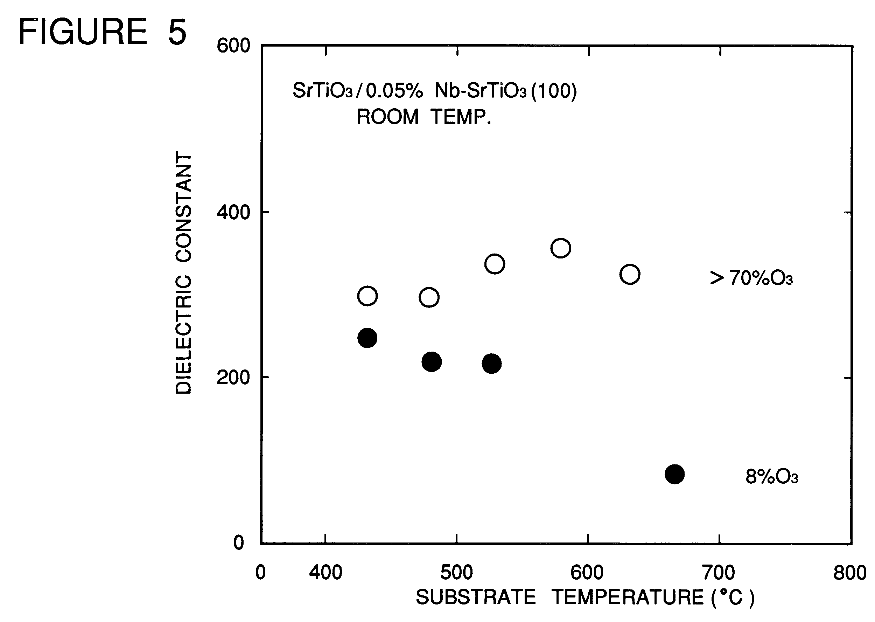

Figure 5 shows graphs of dielectric constants at the room temperature against substrate temperatures at which the SrTiO₃ thin film were deposited. Blank circles show dielectric constants of the SrTiO₃ thin films deposited by supplying O₂ including 70 or a little more volume percent O₃ and dark spots show dielectric constants of the SrTiO₃ thin films deposited by supplying O₂ including 8 percent O₃.

As shown in Figure 5, the SrTiO₃ thin films deposited by supplying O₂ including 70 or a little more volume percent O₃ have higher dielectric constants.

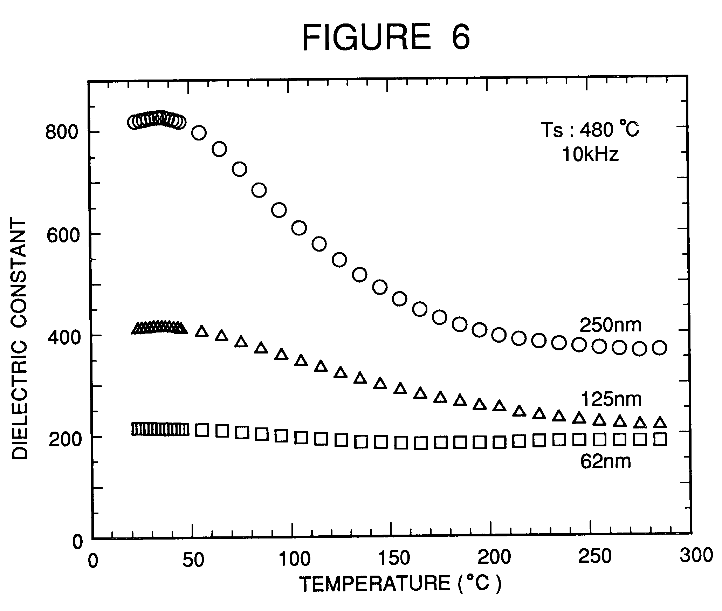

Figure 6 shows graphs of dielectric constants of the SrTiO₃ thin films having thickness of 62, 125 and 250 nanometers against temperatures. The SrTiO₃ thin films were deposited by supplying O₂ including 70 or a little more volume percent O₃ at a substrate temperature of 480 °C and the dielectric constants were measured at a frequency of 10 kHz. As shown in Figure 6, the thicker SrTiO₃ thin films had the higher dielectric constants. The SrTiO₃ thin film having a thickness of 250 nanometers had the maximum dielectric constant of 825 at a temperature of 35 K. This value is the highest of dielectric constants of SrTiO₃ thin films deposited by co-evaporation methods, which have been reported.

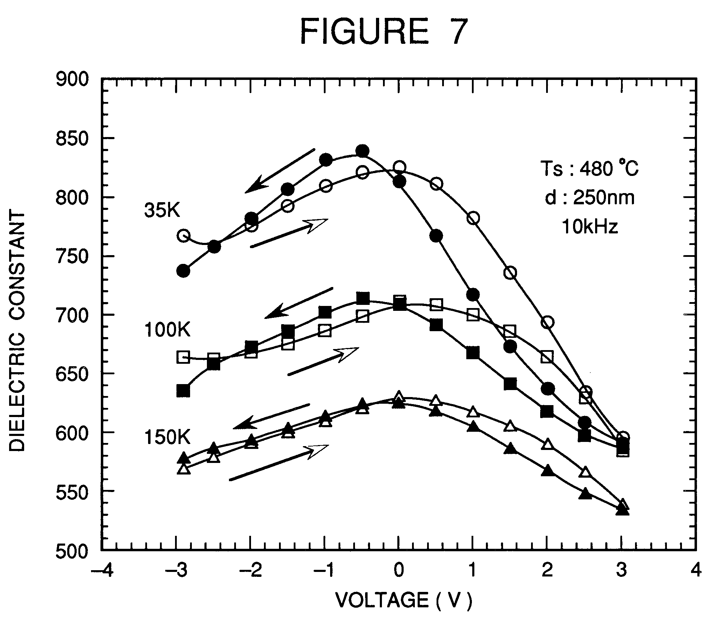

Figure 7 shows graphs of dielectric constants of the SrTiO₃ thin film having a thickness of 250 nanometers against electric fields. The SrTiO₃ thin films were deposited by supplying O₂ including 70 or a little more volume percent O₃ at a substrate temperature of 480 °C and the dielectric constants were measured at a frequency of 10 kHz and temperatures of 35 K, 100 K and 150 K. As shown in Figure 7, the dielectric constants were electric field dependent, which was similar to bulky SrTiO₃.

As explained above, an oxide dielectric thin film having an excellent dielectric properties, which has not been prepared can be obtained by the process in accordance with the present invention. The oxide dielectric thin film prepared by the process in accordance with the present invention is suitable for an insulator layer and dielectric layer of a superconducting device utilizing an oxide superconductor.

The invention has thus been shown and described with reference to the specific embodiments. However, it should be noted that the present invention is in no way limited to the details of the illustrated structures but converts and modifications may be made within the scope of the appended claims.

## Claims

1. A process for preparing a film formed of an oxide superconductor on a substrate by reactive co-evaporation conducted by using an MBE apparatus comprising a vacuum chamber wherein an oxidizing gas is supplied in the proximity of the substrate so that pressure around the substrate is locally elevated and at least one evaporation source wherein said process comprising the steps of;
evacuating the vacuum chamber to a pressure of 1 × 10⁻⁹ torr or lower;
supplying an oxidizing gas selected from the group consisting of O₂ including not less than 5 volume percent O₃, pure N₂O and pure NO₂ so that a pressure in the proximity of the substrate becomes 6 × 10⁻⁶ to 8 × 10⁻⁵ Torr while a pressure in the proximity of the evaporation source becomes 1 × 10⁻⁹ Torr or lower;
heating the substrate; and
emitting a molecular beam onto the heated substrate so that the molecular beam is oxidized on and near the substrate and an oxide superconductor film is deposited on the substrate.

2. A process as claimed in Claim 2; wherein the oxidizing gas is selected from the group consisting of O₂ including not less than 70 volume percent O₃.

3. A process as claimed in Claim 1; wherein the substrate is cooled down to the room temperature after the oxide superconductor film has been deposited, in the atmosphere in which the oxide superconductor film was deposited.

4. A process as claimed in Claim 1; wherein the reactive co-evaporation is effected while the oxidizing gas is struck onto a deposition surface of the substrate.

5. A process as claimed in Claim 1; wherein the oxide superconductor is Y₁Ba₂Cu₃O_{7-δ} oxide superconductor.

6. A process as claimed in Claim 5; wherein the reactive co-evaporation is effected at a substrate temperature 650 to 730 °C.

7. A process as claimed in Claim 6; wherein the reactive co-evaporation is effected at a substrate temperature 700 °C.

8. A process as claimed in Claim 5; wherein metal yttrium, metal barium and metal copper are used as evaporation sources.

9. A process as claimed in Claim 8; wherein the metal yttrium, the metal barium and the metal copper are set to K cells.

10. A process as claimed in Claim 9; wherein the reactive co-evaporation is effected at a temperature of the K cell of the metal yttrium of 1150 to 1350 °C, at a temperature of the K cell of the metal barium of 570 to 640 °C and at a temperature of the K cell of the metal copper of 950 to 1090 °C.

11. A process as claimed in Claim 10; wherein the reactive co-evaporation is effected at a temperature of the K cell of the metal yttrium of 1220 °C, at a temperature of the K cell of the metal barium of 620 °C and at a temperature of the K cell of the metal copper of 1000 °C.

12. A process for preparing a film formed of an oxide dielectric on a substrate by reactive co-evaporation conducted by using an MBE apparatus comprising a vacuum chamber wherein an oxidizing gas is supplied in the proximity of the substrate so that pressure around the substrate is locally elevated and at least one evaporation source wherein said process comprising the steps of;
evacuating the vacuum chamber to a pressure of 1 × 10⁻⁹ torr or lower;
supplying an oxidizing gas selected from the group consisting of O₂ including not less than 5 volume percent O₃, pure N₂O and pure NO₂ so that a pressure in the proximity of the substrate becomes 9 × 10⁻⁶ to 9 × 10⁻⁵ Torr while a pressure in the proximity of the evaporation source becomes 1 × 10⁻⁹ Torr or lower;
heating the substrate; and
emitting a molecular beam onto the heated substrate so that the molecular beam is oxidized on and near the substrate and an oxide dielectric film is deposited on the substrate.

13. A process as claimed in Claim 12; wherein the oxide dielectric is SrTiO₃.

14. A process as claimed claimed in Claim 13; wherein the reactive co-evaporation is effected at a substrate temperature 430 to 580 °C.

15. A process as claimed claimed in Claim 14; wherein the reactive co-evaporation is effected at a substrate temperature 480 °C.

16. A process as claimed in Claim 15; wherein the reactive co-evaporation is effected by using metal strontium and metal titanium as evaporation sources.

17. A process as claimed in Claim 16; wherein the metal strontium and the metal titanium are set to K cells.

18. A process as claimed in Claim 17; wherein the reactive co-evaporation is effected at a temperature of the K cell of the metal strontium of 450 to 600 °C and at a temperature of the K cell of the metal titanium of 1430 °C to 1550 °C.

19. A process as claimed in Claim 18; wherein the reactive co-evaporation is effected at a temperature of the K cell of the metal strontium of 520 °C and at a temperature of the K cell of the metal titanium of 1500 °C.
